# EUROPEAN PATENT APPLICATION

(11) **EP 4 730 955 A1**
(43) Date of publication of application: **22.04.2026**
(21) Application number: 25204926.7
(22) Date of filing: 26.09.2025
(51) Int. Cl.: H10D 30/67, H10D 30/01

(54) **SEMICONDUCTOR DEVICE AND PREPARATION METHOD THEREOF**

(30) Priority: 21.10.2024 CN 202411474851
(71) Applicant: SwaySure Technology Co., Ltd., Shenzhen (CN)
(72) Inventor: PAN, Junbo, Shenzhen (CN)
(74) Representative: Klunker IP Patentanwälte PartG mbB

(57) **Abstract**

The present disclosure discloses a semiconductor device and a preparation method thereof. The preparation method includes: providing a semiconductor structure including a first insulating layer, a source layer located on the first insulating layer, and a second insulating layer located on the source layer; forming a plurality of drain portions embedded and arranged in an array on an upper portion of the second insulating layer; etching the second insulating layer by using the plurality of drain portions as masks until the source layer is exposed, so as to form a plurality of columnar bodies; forming a channel material layer surrounding the columnar bodies in a circumferential direction; and forming a gate dielectric layer and a gate structure on one side of the channel material layer away from the columnar bodies. According to the preparation method provided by the present disclosure, a straighter channel material layer can be formed.

## Description

### TECHNICAL FIELD

The present disclosure relates to the technical field of the semiconductor, and in particular to a semiconductor device and a preparation method thereof.

### BACKGROUND

Generally, when preparing an existing semiconductor device with a vertical transistor structure, a source layer and a first oxide layer located on the source layer are formed first, then a gate layer and a second oxide layer located on the gate layer are formed above the first oxide layer, then a channel hole penetrating the second oxide layer, the gate layer and the first oxide layer is formed, and a channel material layer is subsequently formed in the channel hole. For this preparation method, when forming the channel hole, it is necessary to etch multiple film layers of different materials, and the etching selectivity ratio is difficult to control, causing the overall inner wall of the channel hole to be uneven. A non-straight channel material layer is formed due to the hole morphology, which affects the electrical performance of the semiconductor device. In addition, when etching to expose the source layer and wet cleaning, damage to the top oxide spacer, the bottom oxide substrate and the gate oxide layer will also occur, which will in turn lead to failure of V_{BD} test of the device.

Therefore, there is a need for improvements so as to at least partially solve the above problems.

### SUMMARY

A series of simplified concepts is introduced into the section of Summary, which would be further illustrated in the section of the detailed description. The Summary of the present disclosure does not intend to define the key features and essential technical features of the claimed technical solution, let alone determining the protection scope thereof.

To at least partially solve the above problems, a first aspect of the present disclosure provides a preparation method of a semiconductor device, including:
providing a semiconductor structure including a first insulating layer, a source layer located on the first insulating layer, and a second insulating layer located on the source layer;
forming a plurality of drain portions embedded and arranged in an array on an upper portion of the second insulating layer;
etching the second insulating layer by using the plurality of drain portions as masks until the source layer is exposed, so as to form a plurality of columnar bodies arranged in an array on an upper surface of the source layer, wherein the columnar bodies include insulating columns located on the source layer and the drain portions located on the insulating columns, and the plurality of columnar bodies are spaced apart from each other by first trenches formed by etching the second insulating layer;
forming a channel material layer surrounding the columnar bodies in a circumferential direction; and
forming a gate dielectric layer and a gate structure on one side of the channel material layer away from the columnar bodies.

Exemplarily, the forming a plurality of drain portions embedded and arranged in an array on an upper portion of the second insulating layer includes:
forming a first patterned photoresist layer on an upper surface of the second insulating layer;
etching the second insulating layer by using the first patterned photoresist layer as a mask so as to form a plurality of second trenches on an upper portion of the second insulating layer, the second trenches corresponding to the drain portions one by one;
removing the first patterned photoresist layer and filling the second trenches with a drain material; and
forming the drain portions by polishing an upper surface of the drain material to be flush with the upper surface of the second insulating layer by a chemical mechanical polishing process.

Exemplarily, the forming a channel material layer surrounding the columnar bodies in a circumferential direction includes:
depositing a semiconductor material layer onto an inner surface of the first trenches and an upper surface of the columnar bodies;
wherein a portion of the semiconductor material layer surrounding the columnar bodies in a circumferential direction constitutes the channel material layer.

Exemplarily, before forming the channel material layer surrounding the columnar bodies in the circumferential direction, the preparation method further includes:
performing a pre-cleaning treatment on the first trenches and the columnar bodies.

Exemplarily, the performing a pre-cleaning treatment on the first trenches and the columnar bodies includes:
oxidizing upper surfaces of the drain portions that are damaged when etching the second insulating layer by using the drain portions as the masks; and
removing oxide formed on the upper surfaces of the drain portions by a wet method or a dry method while cleaning the first trenches.

Exemplarily, the forming a gate dielectric layer and a gate structure on one side of the channel material layer away from the columnar bodies includes:
forming the gate dielectric layer conformally covering the semiconductor material layer;
filling the first trenches with an insulating material and flattening a surface to form a third insulating layer, wherein an upper surface of the third insulating layer is higher than an upper surface of the gate dielectric layer;
forming a second patterned photoresist layer on an upper surface of the third insulating layer;
etching the third insulating layer, the gate dielectric layer, the semiconductor material layer and the source layer by using the second patterned photoresist layer as a mask until the first insulating layer is exposed so as to form a plurality of source line cutting trenches, and cutting the source layer into a plurality of source lines extending in a first direction and arranged at intervals in a second direction, each of the source lines connecting a row of the columnar bodies arranged in the first direction, wherein the first direction and the second direction are both parallel to a plane where the first insulating layer is located, and the first direction intersects with the second direction;
filling the source line cutting trenches with an insulating material and flattening a surface to form a fourth insulating layer, wherein an upper surface of the fourth insulating layer is higher than the upper surface of the gate dielectric layer;
etching back the fourth insulating layer to form a first back-etched groove, wherein a bottom of the first back-etched groove is higher than an upper surface of a lowermost side of the gate dielectric layer; and
forming the gate structure in the first back-etched groove.

Exemplarily, the forming the gate structure in the first back-etched groove includes:
filling the first back-etched groove with a gate material and flattening a surface to form a gate material layer;
etching back the gate material layer to form a second back-etched groove, wherein the bottom of the second back-etched groove is lower than upper surfaces of the drain portions;
filling the second back-etched groove with an insulating material and flattening a surface to form a fifth insulating layer;
forming a third patterned photoresist layer on an upper surface of the fifth insulating layer;
etching the fifth insulating layer and the gate material layer by using the third patterned photoresist layer as a mask until the gate dielectric layer is exposed so as to form a plurality of word line cutting trenches, and cutting the gate material layer into a plurality of word lines extending in the second direction and arranged at intervals in the first direction, each of the word lines connecting a row of the columnar bodies arranged in the second direction, wherein a portion of the word lines surrounding one side of the gate dielectric layer away from the columnar bodies constitutes the gate structure; and
filling the word line cutting trenches with an insulating material and flattening a surface until an upper surface of the semiconductor material layer is exposed.

Exemplarily, the gate material layer includes a composite layer of a barrier layer and a gate metal layer;
the filling the first back-etched groove with a gate material and flattening a surface to form a gate material layer includes:
conformally depositing a layer of the barrier layer onto an inner surface of the first back-etched groove and an upper surface of an uppermost side of the gate dielectric layer; and
filling a remaining space of the first back-etched groove with a gate metal material and flattening a surface to form a gate metal layer, wherein an upper surface of the gate metal layer is higher than an upper surface of an uppermost side of the barrier layer; and
the etching back the gate material layer to form a second back-etched groove includes:
   etching back the barrier layer and the gate metal layer such that the upper surface of the uppermost side of the barrier layer is flush with the upper surface of the gate metal layer and is lower than the upper surfaces of the drain portions.

Exemplarily, the barrier layer is a titanium nitride layer; and
the gate metal layer is a tungsten layer.

Exemplarily, the gate dielectric layer includes a silicon dioxide layer and a silicon nitride layer conformally covering the semiconductor material layer in sequence.

Exemplarily, in the step of etching back the fourth insulating layer to form a first back-etched groove, a non-plasma dry etching process is used to etch back the fourth insulating layer.

Exemplarily, the source layer includes a tungsten layer, a titanium nitride layer and a polysilicon layer sequentially deposited on the first insulating layer;
the material of the drain portions is polysilicon; and
the material of the channel material layer is polysilicon.

A second aspect of the present disclosure provides a semiconductor device, wherein the semiconductor device is prepared by the preparation method as mentioned above.

According to the preparation method of the semiconductor device of the present disclosure, the plurality of drain portions are first formed on the upper portion of the second insulating layer located on the source layer. Then, using the drain portions as the masks, the second insulating layer is etched until the source layer is exposed, so as to form the plurality of columnar bodies arranged in an array on the upper surface of the source layer and then form the channel material layer surrounding the columnar bodies in the circumferential direction, wherein the columnar bodies are formed by etching the second insulating layer, which is a single material layer, without involving a variety of material layers. Thus, their circumferential surface can have a better flatness, and a straight channel material layer can be formed on their circumferential surface, thereby effectively improving the performance of the formed semiconductor device. Moreover, according to the preparation method of the semiconductor device of the present disclosure, the channel material layer surrounding the columnar bodies in the circumferential direction is first formed, and then the gate dielectric layer and the gate structure are formed. This avoids the steps of etching to expose the source layer and wet cleaning. Therefore, damage to the top oxide spacer, the bottom oxide substrate and the gate oxide layer can be prevented. In addition, the step of depositing a protective film onto the surface of the gate oxide layer is eliminated, thereby simplifying the process.

### BRIEF DESCRIPTION OF THE DRAWINGS

The following drawings are hereby incorporated as part of the present disclosure for the understanding of the present disclosure. The embodiments are illustrated and described in the drawings in order to explain the devices and principles of the present disclosure. In the drawings,
FIG. 1 is a schematic flowchart of a preparation method of a semiconductor device according to an embodiment of the present disclosure;
FIGS. 2 to 16 are schematic top views of a device in various steps of the preparation method of a semiconductor device according to an embodiment of the present disclosure;
FIGS. 17 to 28 are schematic cross-sectional views along X-X in FIG. 2 to FIG. 13, respectively;
FIGS. 29 to 30 are schematic cross-sectional views along Y-Y in FIG. 14 to FIG. 15, respectively; and
FIGS. 31 to 32 are schematic cross-sectional views along X-X and Y-Y in FIG. 16, respectively.

### EXPLANATION OF REFERENCE NUMBERALS

100-First insulating layer, 110-Source layer, 111-Tungsten layer, 112-Titanium nitride layer, 113-Polysilicon layer, 120-Second insulating layer, 121-Insulating columns, 130-First patterned photoresist layer, 131-Circular opening, 140-Drain portions, 150-Columnar bodies, 160-Semiconductor material layer, 161-Channel material layer, 170-Gate dielectric layer, 171-Silicon dioxide layer, 172-Silicon nitride layer, 180-Third insulating layer, 190-Second patterned photoresist layer, 191-Strip-shaped groove, 200-Source line, 210-Fourth insulating layer, 220-Gate material layer, 221-Barrier layer, 222-Gate metal layer, 230-Fifth insulating layer, 240-Third patterned photoresist layer, 241-Strip-shaped groove, 250-Word line, 260-Insulating material;

10-Second trenches, 20-First trenches, 30-Source line cutting trenches, 40-First back-etched groove, 50-Second back-etched groove, 60-Word line cutting trenches.

### DETAILED DESCRIPTION

In the following description, numerous specific details are set forth in order to provide a more thorough understanding of the present disclosure. However, it is obvious to those skilled in this art that the present disclosure may be implemented without one or more of these details. Some technical features well-known in this art are not described in other examples in order to avoid confusion with the present disclosure.

It is to be understood that the present disclosure can be implemented in various forms, but should not be construed as being limited to the embodiments set forth herein. On the contrary, these embodiments are provided to make the disclosure thorough and complete and the scope of the disclosure be completely conveyed to those skilled in the art. In the drawings, the sizes and relative sizes of layers and regions may be exaggerated for clarity. The same reference numerals represent the same elements throughout the description.

It will be understood that, although the terms such as first, second, third, etc. may be used to describe various elements, components, regions, layers and/or parts, these elements, components, regions, layers and/or parts should not be limited by these terms. These terms are only used to distinguish one element, component, region, layer or part from another element, component, region, layer or part. Therefore, without departing from the teachings of the present disclosure, the first element, component, region, layer or part discussed below could be represented as a second element, component, region, layer or part.

Spatial relationship terms such as "under", "beneath", "below", "down", "on", "above", etc., may be used herein for descriptive convenience to illustrate the relationships between one element or feature and another element(s) or feature(s) shown in the figures. It should be understood that the spatially relationship terms are intended to encompass different orientations of the device in use and operation in addition to the orientation shown in the figures.

The use of the terms provided herein is intended merely to illustrate the embodiments and does not pose a limitation on the present disclosure. When they are used herein, the terms "a", "an" and "the" in the singular form are also intended to include the plural, unless otherwise indicated herein. It should still be understood that the terms "comprising" and/or "including" are used in the description to determine the presence of the features, integers, steps, operations, elements and/or components but not to exclude the presence or addition of one or more other features, integers, steps, operations, elements, components and/or groups. The terms "and/or" as used herein include any or all combinations of related listed items.

Embodiments of the disclosure are described herein with reference to cross-sectional views as schematic diagrams of ideal embodiments (and intermediate structures) of the present disclosure. In this way, variations in the shapes shown due to, for example, manufacturing techniques and/or tolerances can be expected. Hence, the embodiments of the present disclosure should not be limited to the specific shapes shown herein, but include shape deviations resulting from, for example, manufacturing. Therefore, what is shown in the figures is essentially illustrative, and their shapes are not intended to indicate the actual shape of the device and are not intended to limit the scope of the present disclosure.

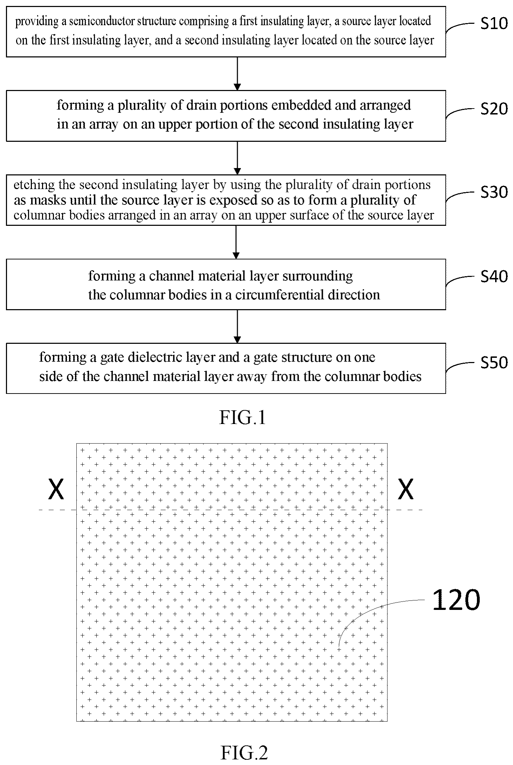

The preparation method of the semiconductor device according to an embodiment of the present disclosure is exemplarily described with reference to FIGS. 1 to 32. Referring to FIG. 1, the preparation method includes the following steps:
S10: providing a semiconductor structure including a first insulating layer, a source layer located on the first insulating layer, and a second insulating layer located on the source layer;
S20: forming a plurality of drain portions embedded and arranged in an array on an upper portion of the second insulating layer;
S30: using the plurality of drain portions as masks to etch the second insulating layer until the source layer is exposed so as to form a plurality of columnar bodies arranged in an array on an upper surface of the source layer, wherein the columnar bodies include insulating columns located on the source layer and the drain portions located on the insulating columns, and the plurality of columnar bodies are spaced apart from each other by first trenches formed by etching the second insulating layer;
S40: forming a channel material layer surrounding the columnar bodies in a circumferential direction; and
S50: forming a gate dielectric layer and a gate structure on one side of the channel material layer away from the columnar bodies.

According to the preparation method of the semiconductor device of the present disclosure, the plurality of drain portions are first formed on the upper portion of the second insulating layer located on the source layer. Then, using the drain portions as the masks, the second insulating layer is etched until the source layer is exposed, so as to form the plurality of columnar bodies arranged in an array on the upper surface of the source layer and then form the channel material layer surrounding the columnar bodies in the circumferential direction, wherein the columnar bodies are formed by etching the second insulating layer, which is a single material layer, without involving a variety of material layers. Thus, their circumferential surface can have a better flatness, and a straight channel material layer can be formed on their circumferential surface, thereby effectively improving the performance of the formed semiconductor device. Moreover, according to the preparation method of the semiconductor device of the present disclosure, the channel material layer surrounding the columnar bodies in the circumferential direction is first formed, and then the gate dielectric layer and the gate structure are formed. This avoids the steps of etching to expose the source layer and wet cleaning. Therefore, damage to the top oxide spacer, the bottom oxide substrate and the gate oxide layer can be prevented. In addition, the step of depositing a protective film onto the surface of the gate oxide layer is eliminated, thereby simplifying the process.

The various steps of the preparation method of the semiconductor device according to an embodiment of the present disclosure will be described in detail below with reference to FIGS. 2 to 32.

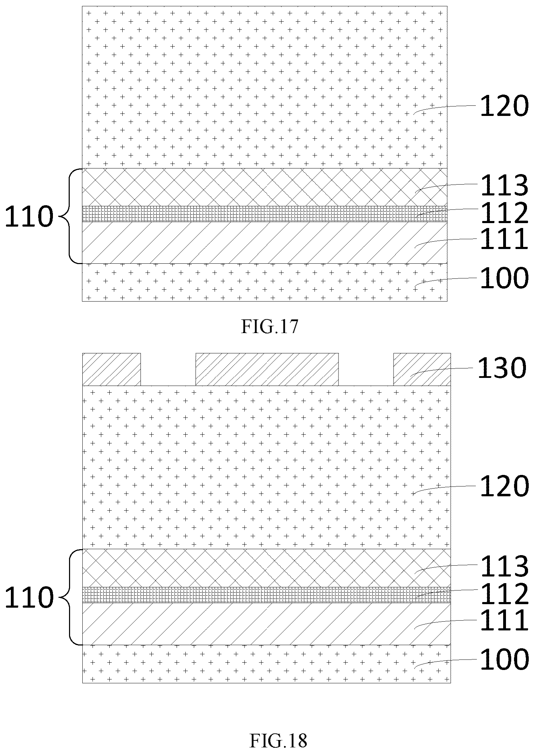

In step S10, referring to FIGS. 2 and 17 (FIG. 17 is a schematic cross-sectional view along X-X in FIG. 2), a semiconductor structure is provided, including a first insulating layer 100, a source layer 110 located on the first insulating layer 100, and a second insulating layer 120 located on the source layer 110.

In this embodiment, the first insulating layer 100 and the second insulating layer 120 are both silicon dioxide layers. The source layer 110 includes a tungsten layer 111, a titanium nitride layer 112, and a polysilicon layer 113 that are sequentially deposited on the first insulating layer 100.

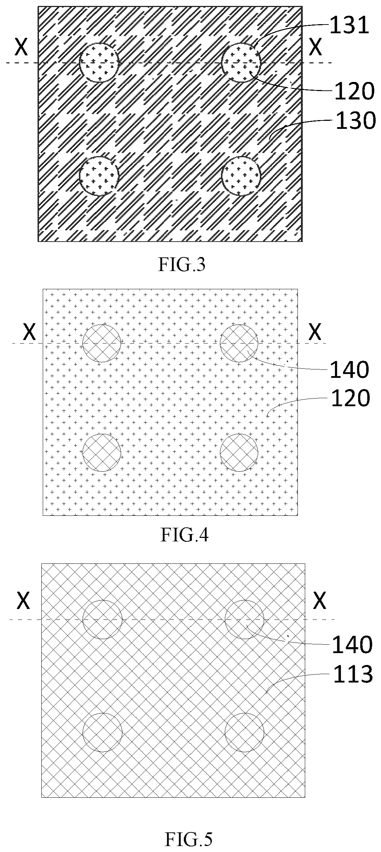

In step S20, referring first to FIGS. 3 and 18 (FIG. 18 is a schematic cross-sectional view along X-X in FIG. 3), a first patterned photoresist layer 130 is formed on the upper surface of the second insulating layer 120. Specifically, a photoresist layer can be formed on the upper surface of the second insulating layer 120 by a process such as spin coating, and then the photoresist layer is patterned by photolithography process steps such as pre-baking, exposure, development, and hardening to form the first patterned photoresist layer 130. The first patterned photoresist layer 130 has a plurality of circular openings 131 arranged in an array.

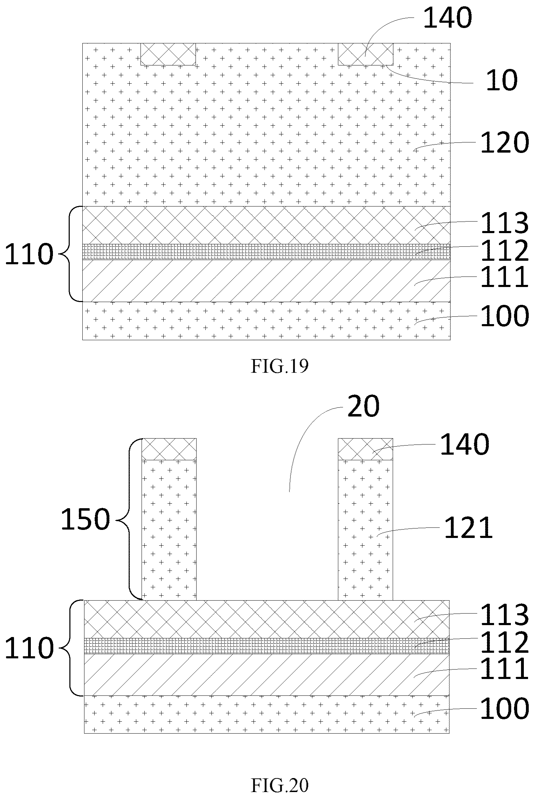

Referring then to FIGS. 4 and 19 (FIG. 19 is a schematic cross-sectional view along X-X in FIG. 4), the second insulating layer 120 is etched with the first patterned photoresist layer 130 as a mask to form a plurality of second trenches 10 on the upper portion of the second insulating layer 120. The depth of the second trenches 10 is much smaller than the thickness of the second insulating layer 120. The second trenches 10 correspond to the drain portions 140 one by one, that is, each second trench 10 is used to form one drain portion 140 subsequently. Afterwards, the first patterned photoresist layer 130 is removed, and the drain material is filled in the second trenches 10. Specifically, the first patterned photoresist layer 130 can be removed by wet degumming, plasma degumming or other degumming methods, and the drain material is filled in the second trenches 10 by a deposition process such as a Chemical Vapor Deposition (CVD) process. The filled drain material, after completely filling the second trenches 10, protrudes beyond the upper surface of the second insulating layer 120. Subsequently, the upper surface of the drain material is polished to be flush with the upper surface of the second insulating layer 120 by a Chemical Mechanical Polishing (CMP) process to form drain portions 140. A plurality of drain portions 140 are embedded into the upper portion of the second insulating layer 120 and arranged in an array in the upper portion of the second insulating layer 120. In this embodiment, the drain material is polysilicon, that is, the material of the formed drain portions 140 is polysilicon.

In step S30, referring to FIGS. 5 and 20 (FIG. 20 is a schematic cross-sectional view along X-X in FIG. 5), using a plurality of drain portions 140 as masks, the second insulating layer 120 is etched by, for example, a dry etching process until the source layer 110 is exposed. Specifically, the polysilicon layer 113 in the source layer 110 is exposed so as to form a plurality of columnar bodies 150 arranged in an array on the upper surface of the source layer 110. The columnar bodies 150 include insulating columns 121 located on the source layer 110 and drain portions 140 located on the insulating columns 121. The insulating columns 121 is formed by etching the remaining part of the second insulating layer 120. The plurality of columnar bodies 150 arranged in an array are spaced apart from each other by the first trenches 20 formed by etching the second insulating layer 120.

Since the etching processes in step S20 and step S30 each involve only etching the second insulating layer 120, which is a single material layer, without involving a variety of material layers, the etching process and quality are easier to control, so that the circumferential surface of the columnar bodies 150 formed by etching can have a better flatness.

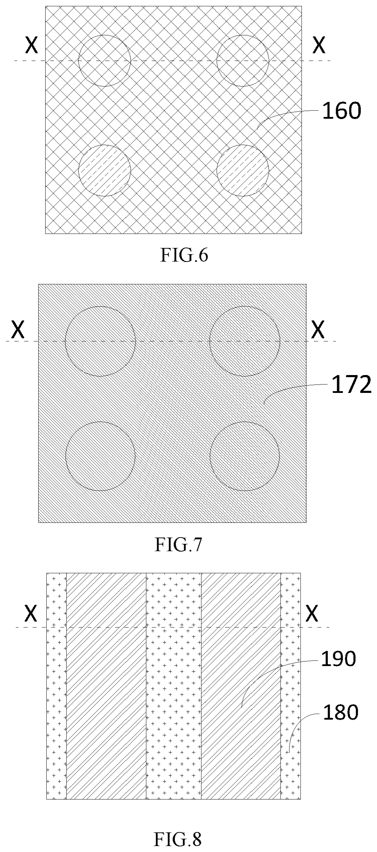

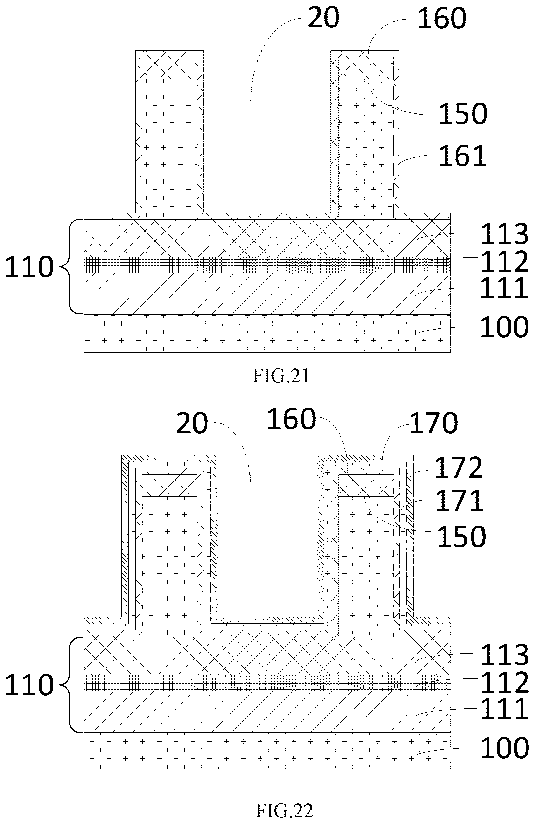

In step S40, referring to FIGS. 6 and 21 (FIG. 21 is a schematic cross-sectional view along X-X in FIG. 6), a semiconductor material layer 160 is deposited onto the inner surface of the first trenches 20 and the upper surface of the columnar bodies 150. Specifically, the semiconductor material layer 160 can be deposited onto the inner surface of the first trenches 20 and the upper surface of the columnar bodies 150 by a deposition process such as a Chemical Vapor Deposition (CVD) process, where a portion of the semiconductor material layer 160 surrounding the columnar bodies 150 in the circumferential direction constitutes a channel material layer 161, and a portion of the semiconductor material layer 160 located on the upper surface of the columnar bodies 150 achieves the same function as the drain portions 140, i.e., as a drain of the semiconductor device. In the present embodiment, the semiconductor material layer 160 is a polycrystalline silicon layer, that is, the material of the channel material layer 161 is polycrystalline silicon.

Due to the better flatness of the circumferential surface of the columnar bodies 150, a straight channel material layer 161 can be formed on the circumferential surface of the columnar bodies 150 in step S40, thereby effectively improving the performance of the semiconductor device finally formed, for example increasing the breakdown voltage (V_{BD}) of the semiconductor device to make the semiconductor device have higher reliability and safety.

As an example, before step S40 (after step S30), the preparation method further includes the step of performing the pre-cleaning treatment on the first trenches 20 and the columnar bodies 150. With the pre-cleaning treatment, the etching residues can be effectively removed, and the cleanliness of the surface of the first trenches 20 and the columnar bodies 150 can be improved, thereby effectively enhancing the quality of deposition of the semiconductor material layer 160 in step S40.

As an example, the pre-cleaning treatment includes: performing an oxidation treatment on the upper surface of the drain portions 140 that was damaged during the etching of the second insulating layer 120 by taking the drain portions 140 as the masks, and then removing oxide formed on the upper surfaces of the drain portions 140 by a wet method or a dry method while cleaning the first trenches 20. By way of example, a thinner oxide layer can be formed on the upper surfaces of the drain portions 140 by a thermal oxidation process. Then, the upper surfaces of the drain portions 140 and the inner surface of the first trenches 20 are cleaned by a wet cleaning process or a dry cleaning process to remove the oxide layer formed on the upper surfaces of the drain portions 140 and the etching residue on the inner surface of the first trenches 20.

When the pre-cleaning treatment is performed before step S40, the channel material layer 161, the gate dielectric layer 170, the gate structure and the like have not yet been formed. Consequently, the pre-cleaning process is not relevant to these structures, and thus could not cause damage to them. There is no need to form a specific protective layer to protect the specific structure before the pre-cleaning treatment, and thereby the process is simple. In the prior art, it is usually necessary to form the specific protective layer to protect the gate oxide layer so as to prevent it from being damaged in the process of etching to expose the source layer and the cleaning process. The protective layer needs to be removed after pre-cleaning, and consequently the process is complicated.

In step S50, referring first to FIGS. 7 and 22 (FIG. 22 is a schematic cross-sectional view along X-X in FIG. 7), a gate dielectric layer 170 conformally covering the semiconductor material layer 160 is formed. In this embodiment, the gate dielectric layer 170 includes a silicon dioxide layer 171 and a silicon nitride layer 172 conformally covering the semiconductor material layer 160 in sequence. Specifically, by means of a deposition process such as the CVD process, a layer of silicon dioxide layer 171 conformally covering the semiconductor material layer 160 may be first deposited, and then a layer of silicon nitride layer 172 conformally covering the silicon dioxide layer 171 may be deposited.

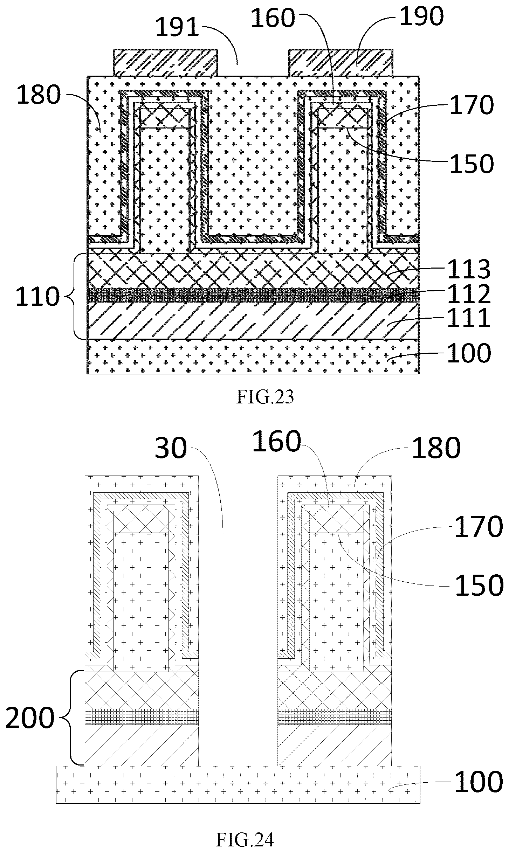

Referring then to FIGS. 8 and 23 (FIG. 23 is a schematic cross-sectional view along X-X in FIG. 8), an insulating material is filled into the first trenches 20 and the surface is flattened to form a third insulating layer 180. The upper surface of the third insulating layer 180 is higher than the upper surface of the gate dielectric layer 170. Afterwards, a second patterned photoresist layer 190 is formed on the upper surface of the third insulating layer 180. In this embodiment, the insulating material is silicon dioxide, and the third insulating layer 180 is a silicon dioxide layer. Specifically, when filling the first trenches 20 with the insulating material, a CVD process may be carried out with tetraethyl orthosilicate (TEOS) as a precursor . In the CVD process, TEOS is introduced into a reaction chamber as a precursor gas. Under certain temperature and pressure conditions, TEOS undergoes thermal decomposition or chemical reactions with other reaction gases to generate silicon dioxide deposited in the first trenches 20 and on the gate dielectric layer 170 above the columnar bodies 150. TEOS is a relatively cheap precursor material, and the CVD process is relatively mature with relatively low equipment costs, so it has a significant cost advantage. After the generated silicon dioxide fills the first trenches 20, it is flattened by a CMP process to form a third insulating layer 180 whose upper surface is higher than the upper surface of the gate dielectric layer 170. Afterwards, a photoresist layer can be formed on the upper surface of the third insulating layer 180 by a process such as spin coating, and then the photoresist layer is patterned by photolithography steps such as pre-baking, exposure, development, and hardening to form a second patterned photoresist layer 190. The second patterned photoresist layer 190 has a plurality of strip grooves 191 extending in the first direction and arranged at intervals in the second direction. The projection of the strip grooves 191 in the first trenches 20 is located between two adjacent rows of columnar bodies 150 (and the semiconductor material layer 160 and the gate dielectric layer 170 located on the circumferential surface thereof) extending and arranged in the first direction.

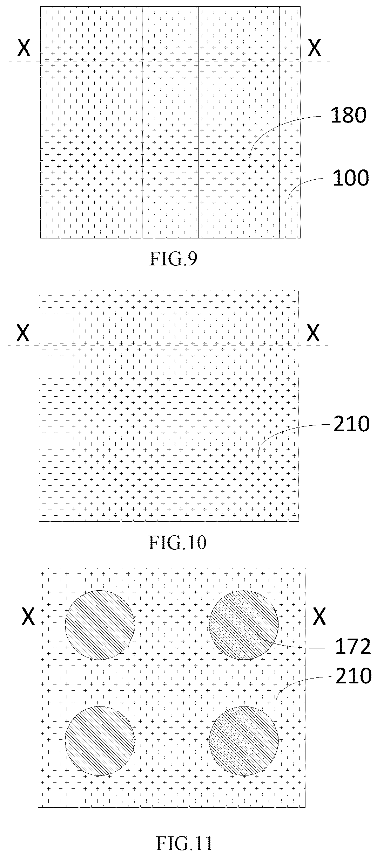

Referring then to FIGS. 9 and 24 (FIG. 24 is a schematic cross-sectional view along X-X in FIG. 9), with the second patterned photoresist layer 190 as a mask, the third insulating layer 180, the gate dielectric layer 170, the semiconductor material layer 160 and the source layer 110 are etched until the first insulating layer 100 is exposed, so as to form a plurality of source line cutting trenches 30. The source layer 110 is cut into a plurality of source lines 200 extending in the first direction and arranged at intervals in the second direction. Each of the source lines 200 is connected to a row of columnar bodies 150 arranged in the first direction. The first direction and the second direction are both parallel to the plane where the first insulating layer 100 is located, and the first direction intersects with the second direction. In this embodiment, the first direction is an up-down direction in FIG. 9, and the second direction is a left-right direction in FIG. 9. The first direction perpendicularly intersects with the second direction. In some other embodiments, the included angle formed between the first direction and the second direction ranges from 0° to 90°.

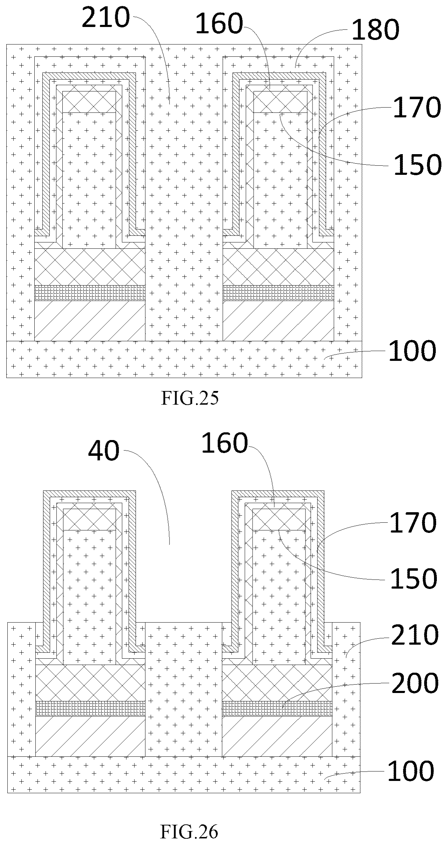

Referring then to FIGS. 10 and 25 (FIG. 25 is a schematic cross-sectional view along X-X in FIG. 10), an insulating material is filled into the source line cutting trenches 30 and the surface is flattened to form a fourth insulating layer 210. The upper surface of the fourth insulating layer 210 is higher than the upper surface of the gate dielectric layer 170. In this embodiment, the insulating material is silicon dioxide, and the fourth insulating layer 210 is a silicon dioxide layer. Specifically, when filling the source line cutting trenches 30 with the insulating material, silicon dioxide can be first deposited into the source line cutting trenches 30 by an Atomic Layer Deposition (ALD) process. The ALD process is a process in which different precursor gases are introduced into the reaction chamber alternately, and a chemical reaction occurs on the surface of the source line cutting trenches 30, resulting in the deposition of thin films layer by layer. For the ALD deposition of silicon dioxide, silicon-containing precursors (such as silane, tetraethoxysilane, etc.) and oxygen-containing precursors (such as oxygen, ozone, water, etc.) are usually used. The ALD process can deposit silicon dioxide conformally and uniformly in a trench with a high aspect ratio, but the deposition rate is lower. After the silicon dioxide deposited by the ALD process has covered the inner wall of the source line cutting trenches 30 to a certain thickness, silicon dioxide is deposited through a CVD process with tetraethyl orthosilicate (TEOS) as a precursor. The rate of depositing silicon dioxide by the CVD process is higher. In the CVD process, TEOS is introduced into the reaction chamber as a precursor gas. Under certain temperature and pressure conditions, TEOS undergoes thermal decomposition or chemical reactions with other reaction gases to generate silicon dioxide deposited in the upper portion of silicon dioxide formed by the ALD process and in the upper portion of the third insulating layer 180 remaining after etching. TEOS is a relatively cheap precursor material, and the CVD process is relatively mature with relatively low equipment costs, so it has a significant cost advantage. Afterwards, the deposited silicon dioxide is flattened by a CMP process to form a fourth insulating layer 210 whose upper surface is higher than the upper surface of the gate dielectric layer 170. By forming the fourth insulating layer 210 successively using the ALD process and the CVD process, the formation quality, production speed, and production cost of the fourth insulating layer 210 can be effectively balanced.

Referring then to FIGS. 11 and 26 (FIG. 26 is a schematic cross-sectional view along X-X in FIG. 11), the fourth insulating layer 210 is etched back to form a first back-etched groove 40. The bottom of the first back-etched groove 40 is higher than the upper surface of the lowermost side of the gate dielectric layer 170. The first back-etched groove 40 exposes the gate dielectric layer 170 located on the upper portions of the columnar bodies 150 and a portion of the gate dielectric layer 170 located in the circumferential direction of the columnar bodies 150. It should be noted that when the fourth insulating layer 210 is etched back, the portion of the third insulating layer 180 remaining from the previous etching is also etched synchronously. Specifically, when the fourth insulating layer 210 is etched back, a non-plasma dry etching process is used to etch back the fourth insulating layer 210 to avoid plasma damage to the silicon nitride layer 172 in the gate dielectric layer 170. As an example, the non-plasma dry etching process can be an etching process known to those skilled in the art, such as a chemical vapor phase reaction etching process.

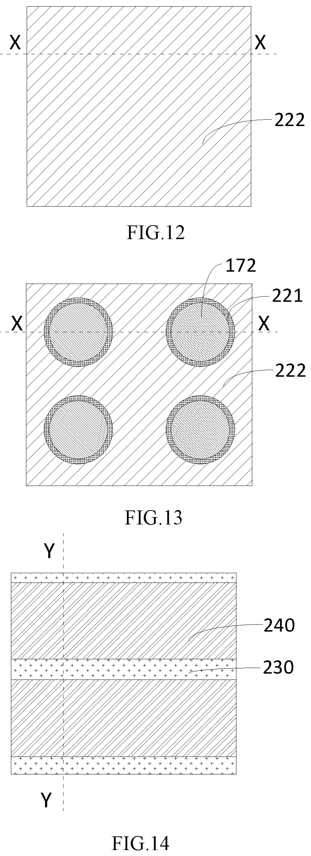

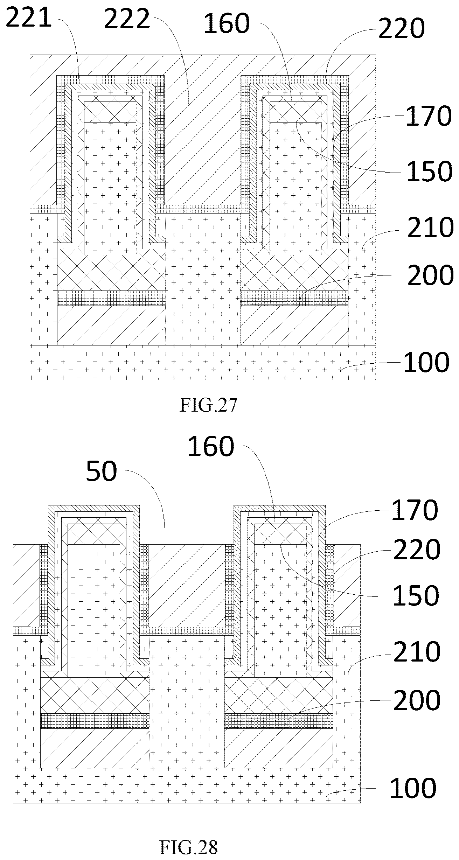

Subsequently, a gate structure is formed in the first back-etched groove 40. Referring first to FIGS. 12 and 27 (FIG. 27 is a schematic cross-sectional view along X-X in FIG. 12), the gate material is filled into the first back-etched groove 40 and the surface is flattened to form a gate material layer 220. In this embodiment, the gate material layer 220 includes a composite layer of a barrier layer 221 and a gate metal layer 222. The barrier layer may be a titanium nitride layer, and the gate metal layer may be a tungsten layer. Specifically, a barrier layer 221 is first conformally deposited on the inner surface of the first back-etched groove 40 and the upper surface of the uppermost side of the gate dielectric layer 170. By way of example, the barrier layer 221 can be deposited by a deposition process such as a CVD process or a PVD process; then, the gate metal material is filled into the remaining space of the first back-etched groove 40 and the surface is flattened to form a gate metal layer 222. The upper surface of the gate metal layer 222 is higher than the upper surface of the uppermost side of the barrier layer 221, that is, the gate metal layer 222 completely covers the barrier layer 221. As an example, the gate metal material can be filled into the remaining space of the first back-etched groove 40 by a deposition process such as a PVD process, a magnetron sputtering process, or an electroplating process, and then the surface thereof is flattened by a CMP process.

Referring then to FIGS. 13 and 28 (FIG. 28 is a schematic cross-sectional view along X-X in FIG. 13), the gate material layer 220 is etched back to form a second back-etched groove 50, where the bottom of the second back-etched groove 50 is lower than the upper surfaces of the drain portions 140. The second back-etched groove 50 exposes at least the gate dielectric layer 170 located on the upper portion of the columnar bodies 150 and the gate dielectric layer 170 located in the circumferential direction of the drain portions 140. Specifically, the barrier layer 221 and the gate metal layer 222 are etched back so that the upper surface of the uppermost side of the barrier layer 221 is flush with the upper surface of the gate metal layer 222 and is lower than the upper surfaces of the drain portions 140. As an example, the barrier layer 221 and the gate metal layer 222 can be etched back simultaneously by a process such as a wet etching process.

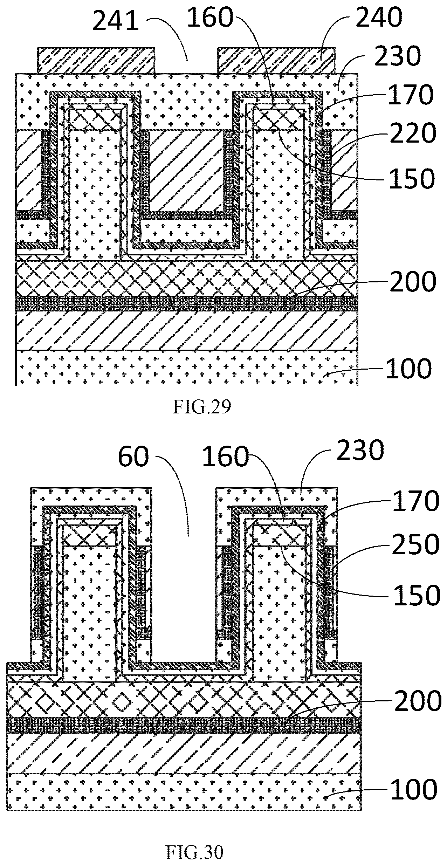

Referring then to FIGS. 14 and 29 (FIG. 29 is a schematic cross-sectional view along Y-Y in FIG. 14), an insulating material is filled into the second back-etched groove 50 and the surface is flattened to form a fifth insulating layer 230. A third patterned photoresist layer 240 is formed on the upper surface of the fifth insulating layer 230. In this embodiment, the insulating material is silicon dioxide, and the fifth insulating layer 230 is a silicon dioxide layer. Specifically, when filling the second back-etched groove 50 with the insulating material, CVD process may be carried out with tetraethyl orthosilicate (TEOS) as a precursor. In the CVD process, TEOS is introduced into the reaction chamber as a precursor gas. Under certain temperature and pressure conditions, TEOS undergoes thermal decomposition or chemical reactions with other reaction gases to generate silicon dioxide deposited in the second back-etched groove 50 and on the upper surface of the uppermost side of the gate dielectric layer 170. TEOS is a relatively cheap precursor material, and the CVD process is relatively mature with relatively low equipment costs, so it has a significant cost advantage. Subsequently, the filled silicon dioxide is flattened by the CMP process to form the fifth insulating layer 230 whose upper surface is higher than the upper surface of the gate dielectric layer 170. Afterwards, a photoresist layer can be formed on the upper surface of the fifth insulating layer 230 by a process such as spin coating, and then the photoresist layer is patterned by photolithography steps such as pre-baking, exposure, development, and hardening to form the third patterned photoresist layer 240. The third patterned photoresist layer 240 has a plurality of strip grooves 241 extending in the second direction and arranged at intervals in the first direction. The projection of the strip grooves 241 in the second trenches 10 is located between two adjacent rows of columnar bodies 150 (and the semiconductor material layer 160, the gate dielectric layer 170 and a small part of the gate material layer 220 located on the circumferential surface thereof) extending and arranged in the second direction.

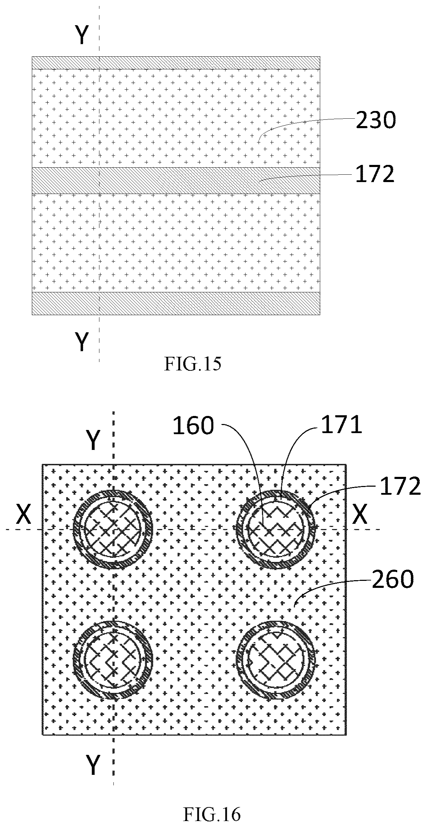

Referring then to FIGS. 15 and 30 (FIG. 30 is a schematic cross-sectional view along Y-Y in FIG. 15), with the third patterned photoresist layer 240 as a mask, the fifth insulating layer 230 and the gate material layer 220 are etched until the gate dielectric layer 170 is exposed to form a plurality of word line cutting trenches 60. The gate material layer 220 is cut into a plurality of word lines 250 extending in the second direction and arranged at intervals in the first direction. Each of the word lines 250 is connected to a row of columnar bodies 150 arranged in the second direction (the word line 250 is connected to the columnar bodies 150 through the gate dielectric layer 170, that is, the word line 250 and the columnar bodies 150 are spaced apart by the gate dielectric layer 170). A portion of the word lines 250 surrounding one side of the gate dielectric layer 170 away from the columnar bodies 150 constitutes the gate structure.

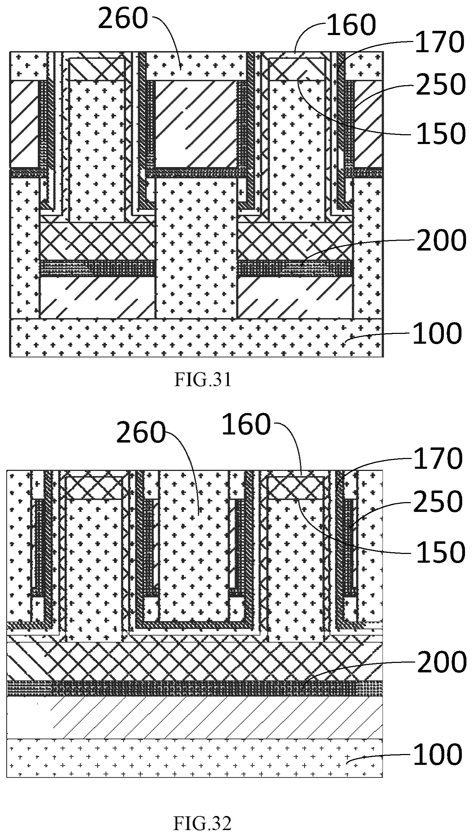

Referring then to FIGS. 16, 31 and 32 (FIG. 31 is a schematic cross-sectional view along X-X in FIG. 16; FIG. 32 is a schematic cross-sectional view along Y-Y in FIG. 16), an insulating material 260 is filled into the word line cutting trenches 60 and the surface is flattened until the upper surface of the semiconductor material layer 160 is exposed. In this embodiment, the insulating material 260 is silicon dioxide. Specifically, when filling the word line cutting trenches 60 with the insulating material 260, silicon dioxide can be first deposited in the word line cutting trenches 60 by an Atomic Layer Deposition (ALD) process. The ALD process is a process in which different precursor gases are introduced into the reaction chamber alternately, and a chemical reaction occurs on the surface of the word line cutting trenches 60, resulting in the deposition of thin films layer by layer. For the ALD deposition of silicon dioxide, silicon-containing precursors (such as silane, tetraethoxysilane, etc.) and oxygen-containing precursors (such as oxygen, ozone, water, etc.) are usually used. The ALD process can deposit silicon dioxide conformally and uniformly in a trench with a high aspect ratio, but the deposition rate is lower. After the silicon dioxide deposited by the ALD process has covered the inner wall of the word line cutting trenches 60 to a certain thickness, silicon dioxide is deposited through a CVD process by using the tetraethyl orthosilicate (TEOS) as a precursor. The rate of depositing silicon dioxide by the CVD process is higher. In the CVD process, TEOS is introduced into the reaction chamber as a precursor gas. Under certain temperature and pressure conditions, TEOS undergoes thermal decomposition or chemical reactions with other reaction gases to generate silicon dioxide deposited in the upper portion of silicon dioxide formed by the ALD process and in the upper portion of the fifth insulating layer 230 remaining after etching. TEOS is a relatively cheap precursor material, and the CVD process is relatively mature with relatively low equipment costs, so it has a significant cost advantage. Afterwards, the semiconductor material layer 160 is used as a grinding stop layer, and the filled silicon dioxide and the gate dielectric layer 170 are flattened by the CMP process until the upper surface of the semiconductor material layer 160 is exposed. By filling the insulating material 260 successively through the ALD process and the CVD process, the filling quality, production speed, and production cost of the insulating material 260 can be effectively balanced.

So far, the relevant steps of the preparation method of the semiconductor device in the embodiment of the present disclosure have been explained. Following the above steps, other conventional steps of fabricating the semiconductor device may also be included, which will not be repeated here. Moreover, the preparation method of this embodiment may include other steps in the above steps or between different steps in addition to the above steps, and these steps can be implemented by various processes in the prior art, which will not be repeated here.

The present disclosure further provides a semiconductor device, which is prepared by the preparation method described above. The semiconductor device provided by the present disclosure can be applied to a memory such as a Dynamic Random Access Memory (DRAM), a Static Random Access Memory (SRAM), and a Flash Memory. Of course, it can also be applied to other storage devices not listed, which are not listed here.

## Claims

1. A preparation method of a semiconductor device, comprising:
providing a semiconductor structure comprising a first insulating layer (100), a source layer (110) located on the first insulating layer (100), and a second insulating layer (120) located on the source layer (110);
forming a plurality of drain portions (140) embedded and arranged in an array on an upper portion of the second insulating layer (120);
etching the second insulating layer (120) by using the plurality of drain portions (140) as masks until the source layer (110) is exposed, so as to form a plurality of columnar bodies (150) arranged in an array on an upper surface of the source layer (110), wherein the columnar bodies (150) comprise insulating columns (121) located on the source layer (110) and the drain portions (140) located on the insulating columns (121), and the plurality of columnar bodies (150) are spaced apart from each other by first trenches (20) formed by etching the second insulating layer (120);
forming a channel material layer (161) surrounding the columnar bodies (150) in a circumferential direction; and
forming a gate dielectric layer (170) and a gate structure on one side of the channel material layer (161) away from the columnar bodies (150).

2. The preparation method of claim 1, wherein:
the forming a plurality of drain portions (140) embedded and arranged in an array on an upper portion of the second insulating layer (120) comprises:
forming a first patterned photoresist layer (130) on the upper surface of the second insulating layer (120);
etching the second insulating layer (120) by using the first patterned photoresist layer (130) as a mask, so as to form a plurality of second trenches (10) on an upper portion of the second insulating layer (120), the second trenches (10) corresponding to the drain portions (140) one by one;
removing the first patterned photoresist layer (130) and filling the second trenches (10) with a drain material; and
forming the drain portions (140) by polishing an upper surface of the drain material to be flush with the upper surface of the second insulating layer (120) by a chemical mechanical polishing process.

3. The preparation method of claim 1, wherein:
the forming a channel material layer (161) surrounding the columnar bodies (150) in a circumferential direction comprises:
depositing a semiconductor material layer (160) onto an inner surface of the first trenches (20) and an upper surface of the columnar bodies (150);
wherein a portion of the semiconductor material layer (160) surrounding the columnar bodies (150) in the circumferential direction constitutes the channel material layer (161).

4. The preparation method of claim 3, wherein:
before forming the channel material layer (161) surrounding the columnar bodies (150) in the circumferential direction, the preparation method further comprises:
performing a pre-cleaning treatment on the first trenches (20) and the columnar bodies (150).

5. The preparation method of claim 4, wherein:
the performing a pre-cleaning treatment on the first trenches (20) and the columnar bodies (150) comprises:
oxidizing upper surfaces of the drain portions (140) that are damaged as when etching the second insulating layer (120) by using the drain portions (140) as the masks; and
removing oxide formed on the upper surfaces of the drain portions (140) by a wet method or a dry method while cleaning the first trenches (20).

6. The preparation method of claim 3, wherein:
the forming a gate dielectric layer (170) and a gate structure on one side of the channel material layer (161) away from the columnar bodies (150) comprises:
forming the gate dielectric layer (170) conformally covering the semiconductor material layer (160);
filling the first trenches (20) with an insulating material and flattening a surface to form a third insulating layer (180), wherein an upper surface of the third insulating layer (180) is higher than an upper surface of the gate dielectric layer (170);
forming a second patterned photoresist layer (190) on an upper surface of the third insulating layer (180);
etching the third insulating layer (180), the gate dielectric layer (170), the semiconductor material layer (160) and the source layer (110) by using the second patterned photoresist layer (190) as a mask until the first insulating layer (100) is exposed, so as to form a plurality of source line cutting trenches (30), and cutting the source layer (110) into a plurality of source lines (200) extending in a first direction and arranged at intervals in a second direction, each of the source lines (200) connecting a row of the columnar bodies (150) arranged in the first direction, wherein the first direction and the second direction are both parallel to a plane where the first insulating layer (100) is located, and the first direction intersects with the second direction;
filling the source line cutting trenches (30) with an insulating material and flattening a surface to form a fourth insulating layer (210), wherein an upper surface of the fourth insulating layer (210) is higher than the upper surface of the gate dielectric layer (170);
etching back the fourth insulating layer (210) to form a first back-etched groove (40), wherein a bottom of the first back-etched groove (40) is higher than an upper surface of a lowermost side of the gate dielectric layer (170); and
forming the gate structure in the first back-etched groove (40).

7. The preparation method of claim 6, wherein:
the forming the gate structure in the first back-etched groove (40) comprises:
filling the first back-etched groove (40) with a gate material and flattening a surface to form a gate material layer (220);
etching back the gate material layer (220) to form a second back-etched groove (50), wherein a bottom of the second back-etched groove (50) is lower than upper surfaces of the drain portions (140);
filling the second back-etched groove (50) with an insulating material and flattening a surface to form a fifth insulating layer (230);
forming a third patterned photoresist layer (240) on an upper surface of the fifth insulating layer (230);
etching the fifth insulating layer (230) and the gate material layer (220) by using the third patterned photoresist layer (240) as a mask until the gate dielectric layer (170) is exposed, so as to form a plurality of word line cutting trenches (60), and cutting the gate material layer (220) into a plurality of word lines extending in the second direction and arranged at intervals in the first direction, each of the word lines connecting a row of the columnar bodies (150) arranged in the second direction, wherein a portion of the word lines surrounding one side of the gate dielectric layer (170) away from the columnar bodies (150) constitutes the gate structure; and
filling the word line cutting trenches (60) with an insulating material and flattening a surface until an upper surface of the semiconductor material layer (160) is exposed.

8. The preparation method of claim 7, wherein:
the gate material layer (220) comprises a composite layer of a barrier layer (221) and a gate metal layer (222);
the filling the first back-etched groove (40) with a gate material and flattening a surface to form a gate material layer (220) comprises:
conformally depositing a layer of the barrier layer (221) onto an inner surface of the first back-etched groove (40) and an upper surface of an uppermost side of the gate dielectric layer (170); and
filling a remaining space of the first back-etched groove (40) with a gate metal material and flattening a surface to form a gate metal layer (222), wherein an upper surface of the gate metal layer (222) is higher than an upper surface of an uppermost side of the barrier layer (221); and
the etching back the gate material layer (220) to form a second back-etched groove (50) comprises:
etching back the barrier layer (221) and the gate metal layer (222) such that the upper surface of the uppermost side of the barrier layer (221) is flush with the upper surface of the gate metal layer (222) and is lower than the upper surfaces of the drain portions (140).

9. The preparation method of claim 8, wherein:
the barrier layer (221) is a titanium nitride layer; and
the gate metal layer (222) is a tungsten layer.

10. The preparation method of claim 6, wherein:
the gate dielectric layer (170) comprises a silicon dioxide layer (171) and a silicon nitride layer (172) conformally covering the semiconductor material layer (160) in sequence.

11. The preparation method of claim 10, wherein:
in the step of etching back the fourth insulating layer (210) to form a first back-etched groove (40), a non-plasma dry etching process is used to etch back the fourth insulating layer (210).

12. The preparation method of claim 1, wherein:
the source layer (110) comprises a tungsten layer (111), a titanium nitride layer (112) and a polysilicon layer (113) sequentially deposited on the first insulating layer (100);
the material of the drain portions (140) is polysilicon; and
the material of the channel material layer (161) is polysilicon.

13. A semiconductor device, wherein the semiconductor device is prepared by the preparation method of any one of claims 1 to 12.
